# FASCICULE DE BREVET EUROPEEN

(11) **EP 3 876 138 B1**
(45) Date de publication et mention de la délivrance du brevet: **23.11.2022**
(21) Numéro de dépôt: 21157690.5
(22) Date de dépôt: 17.02.2021
(51) Int. Cl.: G06K 7/10, G06K 19/07, G11C 14/00

(54) **PROCÉDÉ D'ÉCRITURE DE DONNÉES DANS UNE MÉMOIRE D'UN TRANSPONDEUR SANS CONTACT, ET DISPOSITIF DE TRANSPONDEUR SANS CONTACT CORRESPONDANT**
VERFAHREN ZUM SCHREIBEN VON DATEN IN EINEN SPEICHER EINES KONTAKTLOSEN TRANSPONDERS UND ENTSPRECHENDE KONTAKTLOSE TRANSPONDERVORRICHTUNG
METHOD FOR WRITING DATA IN A MEMORY OF A CONTACTLESS TRANSPONDER, AND CORRESPONDING CONTACTLESS TRANSPONDER DEVICE

(30) Priorité: 03.03.2020 FR 2002132
(43) Date de publication de la demande: 08.09.2021
(73) Titulaire: STMicroelectronics (Rousset) SAS, 13790 Rousset (FR)
(72) Inventeur: TAILLIET, François, 13710 Fuveau (FR); BROCHIER, Beatrice, 06740 Chateauneuf (FR); FIDELIS, Sylvain, 13720 Belcodene (FR)
(74) Mandataire: Casalonga

(56) Documents cités:
- WO-A1-2007/028872
- WO-A1-2013/079885
- FR-A1- 3 007 186

## Description

Des modes de mise en œuvre et de réalisation de l'invention concernent les transpondeurs sans contact ayant une mémoire, et l'écriture de données dans une mémoire d'un transpondeur sans contact.

L'invention s'applique tout particulièrement aux transpondeurs sans contact, notamment des transpondeurs NFC (« Near Field Communication ») ou RFID (« Radio Frequency Identification »), par exemple des étiquettes ou des cartes, usuellement désignés par le terme anglais « tags ».

L'identification radio fréquence, plus connue par l'homme du métier sous la dénomination anglosaxonne RFID (« Radio Frequency Identification ») est un terme générique qui désigne globalement des communications sans contact permettant une identification d'un appareil sur des fréquences radio.

La communication champ proche, plus connue par l'homme du métier sous la dénomination anglosaxonne NFC (« Near Field Communication »), est une technologie de connectivité sans fil qui permet une communication sur une courte distance, par exemple 10 cm, entre des dispositifs électroniques (transpondeurs), comme par exemple des cartes à puce sans contact ou des étiquettes, et des lecteurs. Dans le cas d'étiquettes communiquant avec des lecteurs RFID forte puissance, la distance de la communication peut dépasser 1 mètre.

Un transpondeur sans contact est un transpondeur capable d'échanger des informations via une antenne avec un lecteur sans contact, selon un protocole de communication sans contact, par exemple un protocole compatible avec la technologie NFC.

La technologie NFC est une plate-forme technologique ouverte normalisée dans la norme ISO/IEC 18092 et ISO/IEC 21481 et incorpore de nombreuses normes déjà existantes comme par exemple ISO 14443 ou ISO 15693 utilisées au niveau des protocoles de communication.

Lors d'une transmission d'information entre un lecteur et un transpondeur, le lecteur génère un champ magnétique par l'intermédiaire de son antenne qui est généralement dans les normes classiquement utilisées, une onde sinusoïdale (la porteuse) à 13,56MHz.

Pour transmettre des informations depuis le lecteur vers le transpondeur, le lecteur utilise une modulation d'amplitude de ladite porteuse. La fréquence de cette modulation correspond à une sous-porteuse de ladite porteuse, et la fréquence de cette sous porteuse dépend du protocole de communication utilisé.

Par exemple, la fréquence de la sous-porteuse peut permettre un débit de données à 106kb/s dans la norme ISO-14443, et à 26kb/s dans la norme ISO-15693.

Le transpondeur quant à lui comporte des moyens de traitement configurés pour démoduler la porteuse reçue afin d'obtenir les données transmises depuis le lecteur.

Un transpondeur passif est généralement dépourvu d'alimentation et utilise l'onde issue du lecteur pour alimenter son circuit intégré, par opposition à un transpondeur actif, généralement pourvu d'une source d'alimentation propre telle qu'une une batterie.

Le circuit intégré du transpondeur, passif ou actif, peut comporter une mémoire non-volatile pour enregistrer les données transmises depuis le lecteur, typiquement une mémoire morte électriquement effaçable et programmable EEPROM (« Electrically Erasable Programmable Read Only Memory »).

Ceci est en particulier le cas des transpondeurs destinés à servir de passerelle entre un appareil externe de communication sans contact, par exemple un téléphone mobile multifonction, plus connu sous l'anglicisme « smartphone », et un microcontrôleur d'un système connecté, par exemple un objet connecté tel qu'une montre connectée, ou bien un équipement connecté de domotique, sans que ces exemples ne soient limitatifs.

De tels transpondeurs servant de passerelle peuvent être également appelés « transpondeurs dynamiques » puisque les données stockées dans leur mémoire peuvent varier au cours du temps soit du fait de l'appareil externe de communication sans contact, soit du fait du microcontrôleur, via une liaison filaire.

La demande internationale WO2013/079885 décrit un procédé d'écriture de données dans une mémoire non volatile de carte à puce, s'appuyant sur la norme ISO 7816-4, comprenant : la réception, dans une mémoire volatile tampon de la carte à puce, d'une commande d'écriture ; l'écriture des données à écrire depuis la mémoire tampon vers une adresse prédéfinie stockée dans la mémoire non-volatile ou vers une adresse par défaut, selon le résultat d'une comparaison d'un paramètre d'identification d'objet associé à la commande d'écriture avec un paramètre d'identification d'objet stocké dans la mémoire non volatile ; et un stockage d'une adresse calculée dans la mémoire non volatile en tant qu'adresse prédéfinie pour l'objet associé.

La demande internationale WO2007/028872 décrit un circuit intégré sans-contact passif comprenant une mémoire non-volatile programmable électriquement et un circuit survolteur à accumulation de charge pour fournir la tension élevée pour l'écriture en mémoire des données.

Classiquement, l'écriture de données dans les mémoires non-volatiles des transpondeurs sans contact, par une communication sans contact, est longue et relativement risquée.

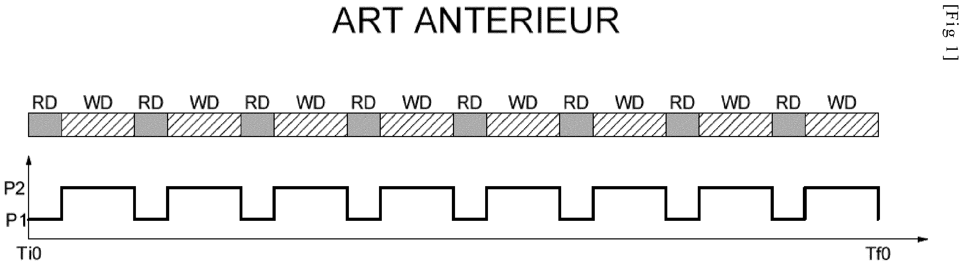

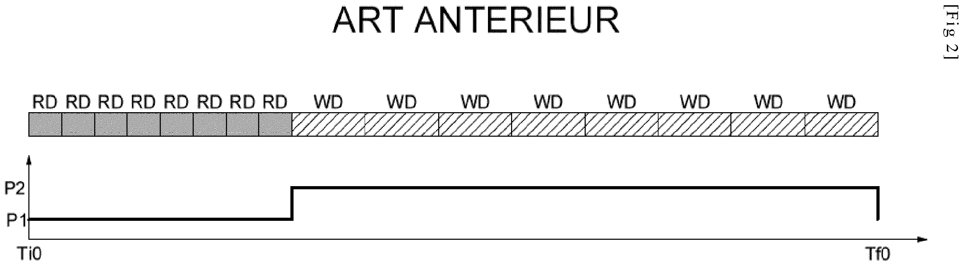

A cet égard on se réfère aux figures 1 et 2.

Les figures 1 et 2 représentent une transaction sans contact entre un lecteur, tel qu'un téléphone mobile multifonction, et un transpondeur, tel qu'une carte NFC. La transaction comprend une transmission sans contact de données RD au transpondeur par le lecteur et une écriture non-volatile WD des données reçues RD par le transpondeur.

Dans le cas de la figure 1, les données reçues RD par le transpondeur sont directement saisies dans des verrous d'écriture de la mémoire EEPROM, et la taille de chaque salve de données RD est limitée par la taille maximale pouvant entrer dans les verrous d'écriture, c'est-à-dire typiquement une page mémoire, comprenant typiquement 4 à 16 octets.

La taille maximale des données RD de chaque salve est ainsi limitée par la taille d'une page de la mémoire (typiquement 4 à 16 octets), et la transaction comprend une séquence de couples phase de réception RD d'une page - cycle d'écriture WD de la page, jusqu'à la fin de la transaction Tf0.

Dans le cas de la figure 2, les données reçues RD par le transpondeur sont d'abord stockées dans une mémoire tampon volatile, et la taille des salves de données RD est limitée par la taille de la mémoire tampon, aisément plus grande qu'une page mémoire de 4 à 16 octets.

Cela étant, l'écriture dans la mémoire EEPROM reste limitée par la taille d'une page par cycle, et des cycles d'écritures WD d'une page chacun sont successivement mis en œuvre après la réception de toutes les données RD.

Dans les deux cas, l'écriture dans la mémoire EEPROM est de la même durée et peut prendre des centaines de millisecondes pour plusieurs kilobits de données. Une durée de quelques centaines de millisecondes n'est pas transparente pour un utilisateur qui doit tenir le transpondeur, par exemple une carte, ou bien tenir le lecteur, par exemple un téléphone mobile multifonction, pendant toute la durée de la transaction.

Par conséquent, étant donné que la durée Tf0-Ti0 d'une transaction est longue, le risque de corruption et de perte des données en cas d'arrachement, c'est-à-dire le retrait hors de la portée de la communication de l'un des appareils sans contact pendant la transaction, est probable et problématique.

En outre, la puissance P2 utilisée par l'écriture WD, qui supérieure à la puissance P1 utilisée par la réception RD, limite la portée dans laquelle le transpondeur doit être maintenu par rapport au lecteur. Plus la puissance dépensée à un instant de la transaction est grande, plus la portée est petite.

Il existe ainsi un besoin d'écrire des données dans la mémoire d'un transpondeur sans contact, passif ou actif, en grande quantité et de façon fiable, en particulier vis-à-vis de potentiels arrachements.

Selon un aspect, il est proposé un procédé d'écriture de données dans une mémoire d'un transpondeur sans contact, la mémoire étant une mémoire vive statique non-volatile comportant des points mémoires comprenant chacun une cellule mémoire volatile et une cellule mémoire non-volatile, le procédé comprenant une phase protocolaire comprenant une réception de données, et un stockage des données reçues dans les cellules mémoires volatiles de la mémoire, et, à l'issue de la phase protocolaire, une phase d'écriture comprenant un unique cycle d'écriture enregistrant les données reçues et stockées dans les cellules mémoires volatiles, dans les cellules mémoires non-volatiles des points mémoires respectifs.

En d'autres termes, il est proposé selon cet aspect d'utiliser les cellules mémoires volatiles de la mémoire vive statique non-volatile comme une mémoire tampon.

Chaque cellule mémoire volatile est par ailleurs combinée, bit par bit dans chaque point mémoire, avec une cellule mémoire non-volatile du type EEPROM.

Par exemple, une cellule mémoire non-volatile est du type EEPROM en ce qu'elle comporte un transistor d'accès et un transistor d'état à grille flottante couplés en série.

Ainsi, d'une part il n'existe aucune différence entre la taille de la « mémoire volatile » et la taille de la « mémoire non-volatile » puisque ces mémoires composent un seul et unique élément de mémoire vive statique non-volatile.

Cela permet avantageusement de recevoir une grande quantité de données, par exemple de taille pouvant égaler la totalité de la taille de la mémoire, sans interrompre la transmission des données pendant la phase protocolaire.

D'autre part, chaque cellule mémoire volatile de la mémoire vive statique non-volatile présente une fonction, lors de la phase d'écriture, comparable à la fonction des verrous d'écriture utilisés dans les techniques classiques de mémoire EEPROM (dont la taille est classiquement limitée à une page).

Or, la taille des données pouvant être écrites en un seul cycle d'écriture selon cet aspect n'est pas limitée à une page de la mémoire, et toutes les données stockées dans les cellules mémoires volatiles (donc éventuellement la totalité de la mémoire) peuvent être transférées dans les cellules mémoires non-volatiles en un seul cycle d'écriture commun, lors de la phase d'écriture.

Et, selon un mode de mise en œuvre, le cycle d'écriture de la phase d'écriture est d'une durée constante, quelle que soit la taille des données reçues lors de la phase protocolaire.

Un seul cycle d'écriture est donc nécessaire pour écrire des données pouvant avoir une taille comprise entre la plus petite unité accessible en écriture dans la mémoire et jusqu'à la totalité de la taille de la mémoire, éventuellement de durée constante. La plus petite unité accessible en écriture, autrement appelée granularité de la mémoire, est par exemple d'un octet (8 bits), tandis que la mémoire peut avoir une taille totale de par exemple 4 kilobits (4096 bits) répartis sur des pages de par exemple 4 octets chacune.

Ainsi, la durée de la phase d'écriture est toujours très courte. Par exemple, la phase d'écriture a une durée de l'ordre de 5 ms (millisecondes).

En conséquence, le risque d'une interruption de la communication sans contact, par exemple à cause d'un arrachement, est extrêmement peu probable pendant une telle durée (5 ms) et le risque de corruption des données est faible, même lors d'une écriture d'une grande quantité de données.

En outre, la durée de la phase d'écriture étant réduite, la consommation d'énergie de la phase d'écriture est également réduite, et cela peut permettre d'augmenter la portée de la communication sans contact.

On remarquera que les avantages mentionnés ci-dessus divergent des applications classiques des mémoires vives statiques non-volatiles « NVSRAM » (pour « Non Volatile Static Random Access Memory »), c'est-à-dire typiquement des applications haut-de-gamme, tels que des serveurs traitant des données sensibles, des boîtes noires de véhicules, des dispositifs médicaux, qui prévoient typiquement l'usage de NVSRAM à des fins d'enregistrement sécurisé des données en cas d'imprévu grave ou d'accident, tout en bénéficiant d'une endurance infinie dans des conditions normales.

Les mémoires NVSRAM sont classiquement plus chères que les mémoires EEPROM, et sont en effet rarement exploitées pour leur capacité en matière de taille de données pouvant être écrites en un cycle.

A cet égard, on pourra se référencer au document publié sous le numéro US 2020/0035293 A1, ainsi qu'à la demande de brevet français déposée le 27 janvier 2020 sous le numéro de dépôt 2000761, qui décrivent des architectures de mémoires vives statiques non-volatiles économiques et permettant notamment de programmer des données à un nombre quelconque d'adresses indépendantes en un seul cycle d'écriture, sans être limité par des données sur une seule page. Ces architectures peuvent avantageusement incorporer la mémoire selon les aspects définis ici.

Cela étant, d'autres mémoires vives statiques non-volatiles NVSRAM classiques prévoient typiquement un processus de rechargement au démarrage, au cours duquel les données antérieures enregistrées dans les cellules mémoires non-volatiles sont chargées dans les cellules mémoires volatiles respectives. Cela consomme du temps et de l'énergie, et est généralement inapproprié dans les transpondeurs bénéficiant d'une énergie limitée et de peu de temps au démarrage pour prévoir ce processus.

Ainsi, selon un mode de mise en œuvre avantageux, seulement les données reçues lors de la phase protocolaire sont stockées dans les cellules mémoires volatiles des points mémoires correspondants, et des données antérieurement enregistrées dans les cellules mémoires non-volatiles d'autres points mémoires ne sont pas rechargées dans les cellules mémoires volatiles desdits autres points mémoires.

Le document publié sous le numéro US 2020/0035303 A1, ainsi que la demande de brevet français déposée le 27 janvier 2020 sous le numéro de dépôt 2000761, décrivent des architectures de mémoire vive statique non-volatile sans rechargement global des données au démarrage. Ces architectures peuvent avantageusement incorporer la mémoire selon les aspects définis ici, et selon le mode de mise en œuvre défini ci-dessus.

Selon un mode de mise en œuvre, le procédé comprend en outre, lors de la phase protocolaire, un emmagasinement d'énergie par un circuit capacitif en quantité suffisante pour alimenter la phase d'écriture en énergie de façon autonome, et, lors de la phase d'écriture, une alimentation de la mémoire avec l'énergie emmagasinée par le circuit capacitif.

Ce mode de mise en œuvre est particulièrement avantageux si le transpondeur est du type passif, c'est-à-dire si le transpondeur utilise l'énergie de l'onde issue d'un lecteur pour alimenter son fonctionnement.

Ainsi, même si le transpondeur est complètement retiré de la portée de la communication sans contact, et est ainsi privé d'énergie, la phase d'écriture pourra se terminer de façon autonome avec l'énergie emmagasinée par le circuit capacitif. Cela permet d'annuler rigoureusement le risque de corruption des données en cas d'arrachement pendant la phase d'écriture.

En outre, emmagasiner l'énergie pendant la durée de la phase protocolaire permet de répartir la consommation d'énergie plus équitablement sur la durée d'une transaction, par rapport à une faible consommation pendant la phase protocolaire et une forte consommation pendant la phase d'écriture. Cela peut permettre d'augmenter la portée de la communication sans contact.

Selon un mode de mise en œuvre, l'unique cycle d'écriture comprend une génération de stimuli d'écriture dans tous les points mémoires du plan mémoire, les stimuli d'écriture étant adaptés pour provoquer l'enregistrement desdites données dans les cellules mémoires non-volatiles de façon automatiquement conditionnée par les données respectivement stockées dans les cellules mémoires volatiles des points mémoires respectifs.

Ce mode de mise en œuvre permet d'écrire directement dans les cellules mémoires non-volatiles les données contenues dans les cellules mémoires volatiles, sans générer les stimuli d'écriture de façon dédiée pour chaque point mémoire selon la donnée stockée. Les demandes de brevets citées ci-avant décrivent des exemples d'architectures de mémoires vives statiques non-volatiles compatibles avec ce mode de mise en œuvre.

Selon un autre aspect, il est proposé un dispositif de transpondeur sans contact comportant une mémoire vive statique non-volatile comportant des points mémoires comprenant chacun une cellule mémoire volatile et une cellule mémoire non-volatile, des moyens de traitement protocolaire configurés pour recevoir des données, et pour stocker des données reçues dans les cellules mémoires volatiles de la mémoire, ainsi que des moyens de traitement d'écriture configurés, à l'issue de la réception et du stockage des données, pour enregistrer en un unique cycle d'écriture les données reçues stockées dans les cellules mémoires volatiles, dans les cellules mémoires non-volatiles des points mémoires respectifs.

Selon un mode de réalisation, les moyens de traitement d'écriture sont configurés de sorte que ledit cycle d'écriture est d'une durée constante, quelle que soit la taille des données reçues par les moyens de traitement protocolaire.

Selon un mode de réalisation, le dispositif comprend en outre un circuit capacitif configuré pour emmagasiner de l'énergie, pendant la réception et le stockage des données par les moyens de traitement protocolaire, en quantité suffisante pour alimenter en énergie de façon autonome les moyens de traitement d'écriture lors dudit cycle d'écriture, et pour alimenter les moyens de traitement d'écriture pendant ledit enregistrement, notamment pendant l'unique cycle d'écriture.

Selon un mode de réalisation, les moyens de traitement protocolaire sont configurés pour stocker seulement les données reçues dans les cellules mémoires volatiles des points mémoires correspondants, et la mémoire est configurée pour ne pas recharger des données antérieurement enregistrées dans les cellules mémoires non-volatiles d'autres points mémoires, dans les cellules mémoires volatiles desdits autres points-mémoires.

Selon un mode de réalisation, les moyens de traitement d'écriture sont configurés, lors dudit cycle d'écriture, pour générer des stimuli d'écriture dans tous les points mémoires de la mémoire, les stimuli d'écriture étant adaptés pour provoquer l'enregistrement desdites données dans les cellules mémoires non-volatiles de façon automatiquement conditionnée par les données respectivement stockées dans les cellules mémoires volatiles des points mémoires respectifs.

D'autres avantages et caractéristiques de l'invention apparaîtront à l'examen de la description détaillée de modes de réalisation et de mise en œuvre, nullement limitatifs, et des dessins annexés, sur lesquels :
[Fig 1]
[Fig 2] précédemment décrites, illustrent des transactions sans contact classiques ;
[Fig 3]

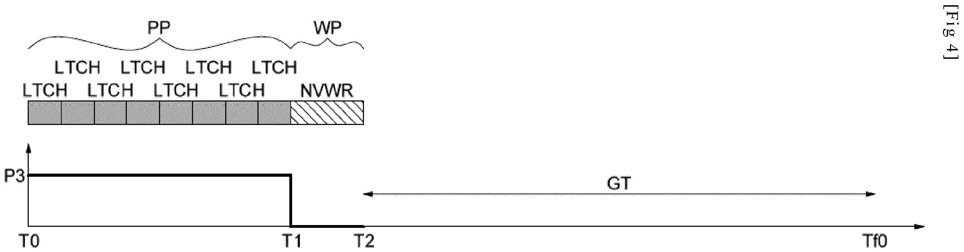

[Fig 4] illustrent des modes de réalisation et de mise en œuvre de l'invention.

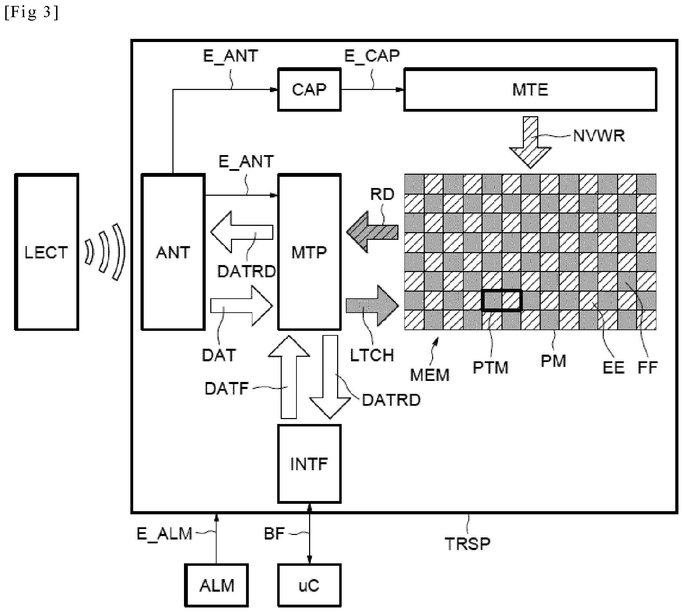

La figure 3 représente un dispositif de transpondeur TRSP du type sans contact, et/ou éventuellement du type transpondeur dynamique destiné à servir de passerelle entre un appareil externe et un microcontrôleur, typiquement d'un objet connecté.

Le transpondeur TRSP est capable d'échanger des informations via une antenne ANT avec un lecteur sans contact LECT, selon un protocole de communication sans contact, par exemple compatible avec la technologie NFC.

La technologie NFC est une plate-forme technologique ouverte normalisée dans la norme ISO/IEC 18092 et ISO/IEC 21481 et incorpore de nombreuses normes déjà existantes comme par exemple ISO 14443 ou ISO 15693 utilisées au niveau des protocoles de communication.

Lors d'une transmission d'information entre le lecteur LECT et le transpondeur TRSP, le lecteur LECT génère un champ magnétique par l'intermédiaire de son antenne (non-représentée) qui est typiquement une onde porteuse sinusoïdale à 13,56MHz. Les informations sont communiquées par une modulation d'amplitude de ladite porteuse.

Le transpondeur TRSP comporte des moyens de traitement protocolaire MTP configurés pour démoduler la porteuse reçue afin d'obtenir les données transmises depuis le lecteur LECT.

Dans une première éventualité, le transpondeur TRSP peut être du type passif, tel qu'une étiquette ou une carte, et est dépourvu d'alimentation. Auquel cas le transpondeur TRSP utilise l'énergie électromagnétique E_ANT de l'onde issue du lecteur LECT, transférée sur son antenne ANT, pour alimenter son fonctionnement.

Dans une deuxième éventualité, le transpondeur TRSP peut être du type actif, et est pourvu de sa propre source d'alimentation ALM, telle qu'une une batterie. Auquel cas le transpondeur TRSP utilise l'énergie E_ALM de la source d'alimentation ALM pour alimenter son fonctionnement.

Enfin, dans une troisième éventualité, le transpondeur TRSP peut être capable de fonctionner à la fois dans un mode passif ou dans un mode actif, tel qu'un transpondeur dynamique appartenant à un objet connecté configuré par exemple pour communiquer en mode actif lorsque que l'objet connecté est activé, ou en mode passif lorsque l'objet connecté est désactivé.

Pour une transmission d'informations du transpondeur TRSP vers le lecteur LECT, le lecteur LECT génère le champ magnétique (la porteuse) sans modulation. En mode passif et en mode actif, le transpondeur TRSP est capable de rétro-moduler le champ généré par le lecteur LECT, en fonction des informations à transmettre, de façon classique par exemple en modifiant la charge connectée aux bornes de l'antenne ANT. Par exemple, les moyens de traitement protocolaires MTP sont configurés pour commander la retro-modulation sur l'antenne ANT.

Lors de l'échange entre le transpondeur TRSP et le lecteur LECT sans contact, les données sont encapsulées dans des trames ayant un format défini en fonction du type de protocole utilisé. Les moyens de traitement protocolaire MTP du transpondeur TRSP sont notamment configurés pour désencapsuler les données DAT qui vont être enregistrées dans la mémoire MEM.

Dans une éventualité où le transpondeur TRSP est un transpondeur dynamique, c'est-à-dire un transpondeur destiné à servir de passerelle entre le lecteur externe LECT et un microcontrôleur uC, par exemple le microcontrôleur d'un objet connecté, le transpondeur TRSP comporte en outre une interface filaire INTF connectée au microcontrôleur uC. Des données DATF à écrire dans la mémoire MEM peuvent ainsi être transmises par le microcontrôleur uC via un bus filaire BF entrant sur l'interface filaire INTF.

Les moyens de traitement protocolaire MTP du transpondeur TRSP sont alors configurés pour en outre traiter suivant le type de protocole utilisé sur le bus filaire BF les données DATF qui vont être enregistrées dans la mémoire MEM.

La mémoire MEM du transpondeur TRSP est une mémoire vive statique non-volatile, du type « NVSRAM » (pour « Non Volatile Static Random Access Memory » en anglais) et comporte des points mémoires PTM comprenant chacun une cellule mémoire volatile FF et une cellule mémoire non-volatile EE.

Les points mémoires PTM sont organisés en matrice dans un plan mémoire PM.

Les cellules mémoires volatiles FF comportent par exemple un verrou bistable composé de deux inverseurs dont les sorties rebouclent chacune sur l'entrée de l'autre inverseur.

Les cellules mémoires non-volatiles EE comportent avantageusement une cellule du type EEPROM, c'est-à-dire un transistor d'état à grille flottante en série avec un transistor d'accès. Par exemple, la borne de conduction du transistor d'accès qui n'est pas couplée avec le transistor d'état est couplée à une sortie du verrou bistable du point mémoire, et à une ligne de bit.

En conséquence, les moyens de traitement protocolaire MTP sont capables de recevoir des données DAT pouvant avoir une taille comprise entre la plus petite unité accessible en écriture dans la mémoire, c'est-à-dire typiquement 1 octet de 8 bits, et la totalité de la taille de la mémoire, par exemple 4 kilobits (4096 bits).

En effet, les moyens de traitement protocolaire MTP sont configurés pour stocker LTCH immédiatement ou quasi immédiatement les données reçues DAT (c'est-à-dire juste après avoir démodulé et désencapsulé le signal reçu) dans les cellules mémoires volatiles FF de la mémoire MEM.

Ainsi, même si le stockage LTCH dans les cellules mémoires volatiles FF du plan mémoire PM est limité par la taille d'une page, les moyens de traitement protocolaire MTP stockent les données DAT à la volée lors des réceptions de la phase protocolaire dans les cellules mémoires volatiles FF (voir ci-après en relation avec la figure 4).

Bien entendu, les moyens de traitement protocolaire MTP sont configurés pour stocker LTCH les données DATF reçues via l'interface de bus filaire INTF de la même façon dans les cellules mémoires volatiles FF de la mémoire MEM.

Par ailleurs, les moyens de traitement protocolaire MTP peuvent inclure des moyens de lecture configurés pour lire RD les données de la mémoire MEM, et transmettre les données lues DATRD soit sans contact via l'antenne ANT, soit sur le bus filaire BF via l'interface filaire INTF. Les moyens de traitement protocolaire MTP sont configurés à cet égard pour formatter, ou encapsuler, les données lues DATRD suivant le type de protocole sans contact ou de protocole filaire utilisé.

En outre, les moyens de traitement protocolaire MTP sont avantageusement configurés pour stocker LTCH seulement les données reçues DAT, DATF dans les cellules mémoires volatiles FF.

En effet, la mémoire MEM est avantageusement configurée pour ne pas recharger des données antérieurement enregistrées dans les cellules mémoires non-volatiles EE vers les cellules mémoires volatiles FF des points-mémoires respectifs, contrairement aux architectures classiques de mémoire vive statique non-volatile NVSRAM.

Par exemple, le document publié sous le numéro US 2020/0035303 A1, ainsi que la demande de brevet français déposée le 27 janvier 2020 sous le numéro de dépôt 2000761, décrivent des architectures de mémoire vive statique non-volatile sans rechargement global des données au démarrage.

Cela permet d'une part de ne pas nécessiter un processus de rechargement des données lors du démarrage du transpondeur TRSP, ainsi de limiter la consommation énergétique non-seulement au démarrage, mais aussi pendant le fonctionnement étant donné qu'il n'est pas nécessaire de systématiquement conserver des données stockées dans toutes les cellules mémoires volatile FF.

Ainsi, lors d'une lecture RD de données DATRD, les moyens de lecture sont capables d'accéder tant aux cellules mémoires volatiles FF qu'aux cellules mémoires non-volatiles EE pour lire des données de la mémoire MEM.

On désignera désormais les données reçues à écrire dans la mémoire par la référence « DAT », indistinctement qu'elles proviennent du lecteur sans contact LECT ou du microcontrôleur filaire uC.

A l'issue de la réception et du stockage LTCH des données DAT dans les cellules mémoires volatiles FF, des moyens de traitement d'écriture MTE enregistrent les données DAT dans les cellules mémoires non-volatiles EE.

Les moyens de traitement d'écriture MTE sont configurés pour enregistrer en un unique cycle d'écriture NVWR les données reçues DAT stockées dans les cellules mémoires volatiles FF, dans les cellules mémoires non-volatiles EE des points mémoires respectifs.

Par exemple, les moyens de traitement d'écriture MTE sont configurés à cet égard pour générer des stimuli d'écriture dans tous points mémoires PTM de la mémoire, ou du moins dans tous les points mémoires PTM qui stockent une donnée dans la cellule mémoire volatile FF.

Les stimuli d'écriture sont avantageusement adaptés pour provoquer l'enregistrement des données dans les cellules mémoires non-volatiles EE de façon automatiquement conditionnée par les données respectivement stockées dans les cellules mémoires volatiles FF des points mémoires respectifs.

Les stimuli d'écriture sont ainsi adaptés pour programmer des données à un nombre quelconque d'adresses indépendantes en un seul cycle d'écriture NVWR, sans être limité par des données sur une seule page.

L'enregistrement des données dans les cellules mémoires non-volatiles se fait par injection de charge dans la grille flottante des transistors d'état, par exemple par effet Fowler-Nordheim ou par phénomène d'injection de porteurs chauds, ou autres mécanismes d'injection de charge, typiquement obtenus par application de stimuli hautes tensions, par exemple de l'ordre de 10 à 15 volts, dans les cellules mémoires volatiles.

Les moyens de traitement d'écriture MTE comportent avantageusement un circuit générateur de hautes tensions, tel que des circuits de pompes de charges, pour générer les stimuli d'écriture dans le plan mémoire PM.

En outre, les cycles d'écriture NVWR sont d'une durée constante, quelle que soit la taille des données reçues DAT par les moyens de traitement protocolaire MTP.

Une architecture de mémoire prévoyant de tels stimuli d'écriture est notamment décrite le document publié sous le numéro US 2020/0035293 A1, ainsi que dans la demande de brevet français déposée le 27 janvier 2020 sous le numéro de dépôt 2000761.

Par conséquent, le temps total de la transaction sans contact est fortement réduit (voir ci-après en relation avec la figure 4), ce qui rend la communication sans contact plus sûre et plus robuste face à l'arrachement lors d'une utilisation par un humain, et par ailleurs augmente le débit d'une chaine de production prévoyant un chargement de données dans la mémoire MEM.

En outre, dans l'exemple de la figure 3, un circuit capacitif CAP est avantageusement prévu pour alimenter en énergie E_CAP de façon autonome les moyens de traitement d'écriture MTE pendant l'enregistrement des données dans les cellules mémoires non-volatiles EE.

Par exemple, le circuit capacitif CAP comprend un circuit comportant un condensateur pour emmagasiner l'énergie, éventuellement une pompe de charge pour augmenter le niveau de la tension chargée dans le condensateur, et éventuellement un dispositif logique classique permettant de commuter entre un mode de charge dans lequel le condensateur emmagasine l'énergie E_ANT transférée sur l'antenne ANT, et un mode d'alimentation dans lequel le condensateur fournit l'énergie emmagasinée E_CAP à la mémoire MEM.

Ainsi, si le circuit capacitif CAP est correctement chargé à la fin de la phase protocolaire, alors le cycle d'écriture NVWR ne peut pas échouer, une fois qu'il a commencé.

Le circuit capacitif CAP peut être configuré pour emmagasiner de l'énergie E_ANT en quantité suffisante pendant la phase protocolaire, c'est-à-dire la phase de réception et de stockage LTCH des données DAT par les moyens de traitement protocolaire MTP.

En effet, si la taille des données transmises lors de la phase protocolaire est grande, le temps de charge du circuit capacitif CAP sera d'autant plus long, permettant d'avoir des courants de charge faibles et un impact limité sur la consommation pendant la réception des données.

La présence de l'élément capacitif CAP est particulièrement avantageuse si le transpondeur TRSP est configuré pour utiliser l'énergie E_ANT recueillie sur l'antenne ANT pour alimenter son fonctionnement, c'est-à-dire dans l'éventualité où le transpondeur TRSP est du type passif, ou est capable de fonctionner dans un mode passif.

Dans l'éventualité où le transpondeur TRSP est toujours en mode passif, le bloc ALM illustré sur la figure 3 n'est pas présent.

Dans l'éventualité où le transpondeur TRSP est toujours en mode actif, c'est-à-dire muni d'une alimentation ALM fournissant l'énergie E_ALM pour alimenter son fonctionnement, l'élément capacitif n'est pas nécessaire pour alimenter les moyens de traitement d'écriture MTE de façon autonome pendant le cycle d'écriture NVWR.

Néanmoins, charger l'élément capacitif CAP avec l'énergie E_ALM fournie par l'alimentation ALM pendant la phase protocolaire (non-représenté) afin d'alimenter les moyens de traitement d'écriture MTE pendant le cycle d'écriture NVWR, peut permettre de répartir la consommation d'énergie et d'éviter un pic de consommation sur l'alimentation ALM au moment de la phase d'écriture NVWR.

La figure 4 représente un exemple de transaction sans contact entre un lecteur, tel qu'un téléphone mobile multifonction, et un transpondeur sans contact TRSP tel que décrit ci-dessus en relation avec la figure 3.

Dans cet exemple, la transaction est faite depuis le lecteur vers le transpondeur TRSP, pour mettre en œuvre un procédé d'écriture de données DAT dans la mémoire MEM du transpondeur TRSP.

Le procédé comprend une phase protocolaire PP comprenant une réception de données pouvant avoir une taille comprise entre la plus petite unité accessible en écriture dans la mémoire et la totalité de la taille de la mémoire, et un stockage LTCH immédiat ou quasi immédiat des données reçues dans les cellules mémoires volatiles de la mémoire.

Par exemple, à chaque réception de données faisant la taille d'une page de la mémoire MEM, les moyens de traitement protocolaire MTP stockent à la volée LTCH la page de donnée reçue DAT dans les cellules mémoires volatiles FF, et continuent de recevoir parallèlement les données de la page suivante.

A l'issue de la phase protocolaire PP, une phase d'écriture WP est mise en œuvre. La phase d'écriture WP comprend un unique cycle d'écriture NVWR enregistrant les données reçues et stockées dans les cellules mémoires volatiles, dans les cellules mémoires non-volatiles des points mémoires respectifs.

Ainsi, des données pouvant avoir une taille comprise entre la plus petite unité accessible en écriture dans la mémoire et la totalité de la taille de la mémoire, sont écrites dans les cellules mémoires non-volatile en un seul cycle d'écriture NVWR, de par exemple 5ms (millisecondes).

Cela produit un gain de temps considérable par rapport aux techniques classiques qui cumulent des cycles d'écritures de 5ms par page.

La durée totale du procédé d'écriture selon l'exemple de la figure 4 (en relation avec la figure 3) va maintenant être comparée avec la durée des procédés d'écriture classiques, tels que décrits précédemment en relation avec la figure 2, dans un exemple d'application d'écritures de 4kbits (4 kilobits, soit 4096 bits) dans une mémoire dont les pages font 4 octets, selon deux types de protocoles de communication compatibles avec la technologie NFC.

Par exemple, le premier protocole considéré est le protocole défini dans la norme ISO 14443, auquel est typiquement associé un débit de communication sans contact de 106kbits/s (kilobits par secondes) ; tandis que le deuxième protocole considéré est le protocole défini dans la norme ISO 15693 auquel est typiquement associé un débit de communication sans contact de 26kbits/s (kilobits par seconde).

Dans la suite, on désignera par « protocole ISO 14443 » et « protocole ISO 15693 » les protocoles de communication définis dans les normes respectives.

Ainsi, dans le procédé d'écriture illustré par la figure 4, la durée T1-T0 de la phase protocolaire PP est de 40ms pour 4096 bits à 106kb/s dans le protocole ISO 14443 ; ou de 158ms pour 4096 bits à 26kb/s dans le protocole ISO 15693.

La durée T2-T1 de la phase d'écriture WP est toujours de 5ms dans les deux technologies.

La durée totale T2-T0 du procédé est donc de 45ms dans le protocole ISO 14443, et de 163ms dans le protocole ISO 15693.

En comparaison, dans le procédé d'écriture classique illustré par la figure 2, la durée des réceptions des données RD est également de 40ms pour 4096 bits à 106kb/s dans le protocole ISO 14443 ; ou également de 158ms pour 4096 bits à 26kb/s dans le protocole ISO 15693.

La durée des écritures WD est quant à elle définie par le nombre de cycles d'écriture d'une page de 4 octets, de 5ms chacun, dans les deux technologies.

Cela représente 128 cycles d'écriture de 5ms, soit 640 ms pour écrire les 4kbits dans la mémoire non-volatile du type EEPROM.

La durée totale Tf0-Ti0 du procédé classique est donc de 680ms dans le protocole ISO 14443, et de 798ms dans le protocole ISO 15693.

En d'autres termes, le gain de temps GT (T2-Tf0) obtenu par le procédé illustré par la figure 4 correspond à un procédé d'écriture sensiblement 15 fois plus rapide en protocole ISO 14443, et sensiblement 5 fois plus rapide en protocole ISO 15693, que les transactions classiques.

Du point de vue de la consommation d'énergie, on considère que la consommation électrique d'un cycle d'écriture d'une page de 4 octets dans une mémoire du type EEPROM classique est de typiquement 25µA (micro ampère).

La puissance fournie pour un tel cycle d'écriture classique WD est notée P2 (figures 1 et 2).

La mémoire vive statique non-volatile MEM décrite précédemment en relation avec la figure 3, a une consommation de par exemple 200µA pour l'unique cycle d'écriture NVWR.

On considère le cas où la mémoire MEM comporte le circuit capacitif CAP tel que décrit précédemment en relation avec la figure 3, qui est chargé pendant la phase protocolaire PP. On rappelle que la phase protocolaire PP dure 40ms dans le protocole ISO 14443, ou 158ms dans le protocole ISO 15693.

La puissance fournie lors de la phase protocolaire PP, pour emmagasiner l'énergie par le circuit capacitif CAP en quantité suffisante pour alimenter la phase d'écriture WP de façon autonome, est notée P3.

On tolère une chute de tension de 4,5V (volts) en fin de cycle d'écriture NVWR pour un condensateur initialement chargé à 6V en début du cycle d'écriture NVWR.

La valeur capacitive du condensateur est paramétrée en conséquence à 220nF (nano farad) minimum.

Ainsi, dans le cas du protocole ISO 14443, pour charger un condensateur de 220nF à 6V en 40ms (PP) avec une pompe de charge de rendement moyen estimé à 50% (estimation pessimiste), un courant de charge moyen de 66µA est consommé pendant la phase protocolaire PP.

Cela se traduit par une puissance P3 supérieure à la puissance P2, dans le protocole ISO 14443.

Dans le cas du protocole ISO 15693, pour charger un condensateur de 220nF à 6V en 158ms (PP) avec une pompe de charge de rendement moyen estimé à 50% (estimation pessimiste), un courant de charge moyen de 16,7µA est consommé pendant la phase protocolaire PP.

Cela se traduit par une puissance P3 inférieure à la puissance P2, dans le protocole ISO 15693.

En conséquence, le dispositif et le procédé décrits en relation avec les figures 3 et 4, consomment moins de puissance que les transactions classiques dans le protocole ISO 15693 et permettent ainsi d'augmenter la portée de la communication sans contact. Ceci est particulièrement avantageux étant donné qu'une longue portée est un atout principal du protocole ISO 15693.

Par contre, la portée de la communication sans contact dans le protocole ISO 14443 peut être réduite. Ceci n'est pas un problème étant donné que la portée n'est pas un atout majeur du protocole ISO 14443. Le protocole ISO 14443 est principalement avantageux pour la vitesse de communication, or le dispositif et le procédé décrits en relation avec les figures 3 et 4 permet d'accélérer la transaction d'un facteur 15 (voir application ci-dessus).

En résumé, le dispositif de transpondeur sans contact TRSP décrit ci-avant, comporte une mémoire vive statique non-volatile à la place d'une mémoire non-volatile classique du type EEPROM, non-pas pour bénéficier de l'avantage originel des NVSRAM d'une endurance illimitée pour une mémoire non-volatile, mais pour exploiter la particularité du fonctionnement de l'écriture non-volatile spécifique aux mémoires vives statiques non-volatiles qui fait que la taille des données écrites en un cycle d'écriture n'est pas limitée à une page (en particulier les mémoires vives statiques non-volatiles décrites dans les documents publiés sous les numéros US 2020/0035293 A1 et US 2020/0035303 A1, et/ou encore dans la demande de brevet français déposée le 27 janvier 2020 sous le numéro de dépôt 2000761).

Cela permet de programmer de grandes quantités de données dans un seul cycle d'écriture, ce qui réduit le temps des transactions des protocoles ISO 14443 et ISO 15693, et améliore de ce fait la résistance contre l'altération des données.

Prévoir le circuit capacitif CAP permet de compenser la consommation relativement élevée du cycle d'écriture unique, et en outre d'être encore plus résistant face à l'altération des données, et la possibilité d'une plus grande portée de communication sans contact.

Ainsi, au global, le débit d'écriture est plus rapide, les opérations d'écriture sont plus sûres, et la portée peut être plus grande.

Par ailleurs, de nombreux cas d'utilisation peuvent bénéficier du processus d'écriture plus sûr et plus rapide, en particulier pour une grande quantité de données, comme par exemple une programmation personnalisée en fin de chaîne de production de transpondeurs sans contact, des mises à jour de micrologiciels, etc.

## Revendications

1. Procédé d'écriture de données dans une mémoire (MEM) d'un transpondeur sans contact (TRSP), la mémoire étant une mémoire vive statique non-volatile comportant des points mémoires (PTM) comprenant chacun une cellule mémoire volatile (FF) et une cellule mémoire non-volatile (EE), le procédé comprenant une phase protocolaire (PP) comprenant une réception de données (DAT), et un stockage des données reçues (LTCH) dans les cellules mémoires volatiles (FF) de la mémoire, et, à l'issue de la phase protocolaire (PP), une phase d'écriture (WP) comprenant un unique cycle d'écriture (NVWR) enregistrant les données reçues et stockées dans les cellules mémoires volatiles (FF), dans les cellules mémoires non-volatiles (EE) des points mémoires respectifs.

2. Procédé selon la revendication 1, dans lequel ledit cycle d'écriture (NVWR) de la phase d'écriture (WP) est d'une durée constante (T2-T1), quelle que soit la taille des données reçues lors de la phase protocolaire (PP).

3. Procédé selon l'une des revendications 1 ou 2, comprenant en outre, lors de la phase protocolaire (PP), un emmagasinement d'énergie par un circuit capacitif (CAP) en quantité suffisante pour alimenter la phase d'écriture (WP) en énergie de façon autonome, et, lors de la phase d'écriture (WP), une alimentation de la mémoire (MEM) avec l'énergie emmagasinée par le circuit capacitif (CAP).

4. Procédé selon l'une des revendications précédentes, dans lequel seulement les données (DAT) reçues lors de la phase protocolaire (PP) sont stockées dans les cellules mémoires volatiles (FF) des points mémoires (PTM) correspondants, et des données antérieurement enregistrées dans les cellules mémoires non-volatiles (EE) d'autres points mémoires ne sont pas rechargées dans les cellules mémoires volatiles (FF) desdits autres points-mémoires.

5. Procédé selon l'une des revendications précédentes, dans lequel l'unique cycle d'écriture (NVWR) comprend une génération de stimuli d'écriture dans tous les points mémoires (PTM) de la mémoire, les stimuli d'écriture étant adaptés pour provoquer l'enregistrement desdites données dans les cellules mémoires non-volatiles (EE) de façon automatiquement conditionnée par les données respectivement stockées dans les cellules mémoires volatiles (FF) des points mémoires respectifs (PTM).

6. Dispositif de transpondeur sans contact (TRSP) comportant une mémoire vive statique non-volatile (MEM) comportant des points mémoires (PTM) comprenant chacun une cellule mémoire volatile (FF) et une cellule mémoire non-volatile (EE), des moyens de traitement protocolaire (MTP) configurés pour recevoir des données (DAT), et pour stocker (LTCH) des données reçues (DAT) dans les cellules mémoires volatiles (FF) de la mémoire, ainsi que des moyens de traitement d'écriture (MTE) configurés, à l'issue de la réception et du stockage des données (DAT), pour enregistrer en un unique cycle d'écriture (NVWR) les données reçues stockées dans les cellules mémoires volatiles (FF), dans les cellules mémoires non-volatiles (EE) des points mémoires respectifs.

7. Dispositif selon la revendication 6, dans lequel les moyens de traitement d'écriture (MTE) sont configurés de sorte que ledit cycle d'écriture (NVWR) est d'une durée constante, quelle que soit la taille des données reçues (DAT) par les moyens de traitement protocolaire (MTP).

8. Dispositif selon l'une des revendications 6 ou 7, comprenant en outre un circuit capacitif (CAP) configuré pour emmagasiner de l'énergie (E_ANT), pendant la réception et le stockage des données par les moyens de traitement protocolaire (MTP), en quantité suffisante pour alimenter en énergie de façon autonome les moyens de traitement d'écriture (MTE) lors dudit cycle d'écriture (NVWR), et pour alimenter (E_CAP) les moyens de traitement d'écriture (MTE) pendant ledit enregistrement.

9. Dispositif selon l'une des revendications 6 à 8, dans lequel les moyens de traitement protocolaire (MTP) sont configurés pour stocker seulement les données reçues (DAT) dans les cellules mémoires volatiles (FF) des points mémoires correspondants, et la mémoire (MEM) est configurée pour ne pas recharger des données antérieurement enregistrées dans les cellules mémoires non-volatiles (EE) d'autres points mémoires, dans les cellules mémoires volatiles (FF) desdits autres points-mémoires.

10. Dispositif selon l'une des revendications 6 à 9, dans lequel les moyens de traitement d'écriture (MTE) sont configurés, lors dudit cycle d'écriture (NVWR), pour générer des stimuli d'écriture dans tous les points mémoires (PTM) de la mémoire, les stimuli d'écriture étant adaptés pour provoquer l'enregistrement desdites données (DAT) dans les cellules mémoires non-volatiles (EE) de façon automatiquement conditionnée par les données (DAT) respectivement stockées dans les cellules mémoires volatiles (FF) des points mémoires respectifs.

## Patentansprüche

1. Verfahren zum Schreiben von Daten in einen Speicher (MEM) eines kontaktlosen Transponders (TRSP), wobei es sich bei dem Speicher um einen nichtflüchtigen statischen Direktzugriffsspeicher handelt, der Speicherpunkte (PTM) umfasst, die jeweils eine flüchtige Speicherzelle (FF) und eine nichtflüchtige Speicherzelle (EE) umfassen, wobei das Verfahren eine Protokollphase (PP) umfasst, die ein Empfangen von Daten (DAT) und ein Speichern der empfangenen Daten (LTCH) in den flüchtigen Speicherzellen (FF) des Speichers umfasst, und, am Ende der Protokollphase (PP), eine Schreibphase (WP), die einen einzigen Schreibzyklus (NVWR) umfasst, bei dem die empfangenen und in den flüchtigen Speicherzellen (FF) gespeicherten Daten in den nichtflüchtigen Speicherzellen (EE) der jeweiligen Speicherpunkte registriert werden.

2. Verfahren nach Anspruch 1, wobei der Schreibzyklus (NVWR) der Schreibphase (WP) unabhängig von der Größe der in der Protokollphase (PP) empfangenen Daten eine konstante Dauer (T2-T1) aufweist.

3. Verfahren nach einem der Ansprüche 1 oder 2, das in der Protokollphase (PP) weiter ein Speichern von Energie durch eine kapazitive Schaltung (CAP) in ausreichender Menge, um die Schreibphase (WP) autonom mit Energie zu versorgen, und in der Schreibphase (WP) ein Versorgen des Speichers (MEM) mit der von der kapazitiven Schaltung (CAP) gespeicherten Energie umfasst.

4. Verfahren nach einem der vorstehenden Ansprüche, wobei nur die in der Protokollphase (PP) empfangenen Daten (DAT) in den flüchtigen Speicherzellen (FF) der entsprechenden Speicherpunkte (PTM) gespeichert werden, und früher in den nichtflüchtigen Speicherzellen (EE) anderer Speicherpunkte registrierte Daten nicht erneut in die flüchtigen Speicherzellen (FF) der anderen Speicherpunkte geladen werden.

5. Verfahren nach einem der vorstehenden Ansprüche, wobei der einzige Schreibzyklus (NVWR) ein Erzeugen von Schreibimpulsen in allen Speicherpunkten (PTM) des Speichers umfasst, wobei die Schreibimpulse geeignet sind, das automatisch von den jeweils in den flüchtigen Speicherzellen (FF) der jeweiligen Speicherpunkte (PTM) gespeicherten Daten bedingte Registrieren der Daten in den nichtflüchtigen Speicherzellen (EE) zu bewirken.

6. Kontaktlose Transpondervorrichtung (TRSP), die einen nichtflüchtigen statischen Direktzugriffsspeicher (MEM), der Speicherpunkte (PTM) umfasst, die jeweils eine flüchtige Speicherzelle (FF) und eine nichtflüchtige Speicherzelle (EE) umfassen, Protokollverarbeitungsmittel (MTP), die so ausgelegt sind, dass sie Daten (DAT) empfangen und empfangene Daten (DAT) in den flüchtigen Speicherzellen (FF) des Speichers speichern (LTCH), sowie Schreibverarbeitungsmittel (MTE) umfasst, die so ausgelegt sind, dass sie am Ende des Empfangs und des Speicherns der Daten (DAT) die empfangenen, in den flüchtigen Speicherzellen (FF) gespeicherten Daten in einem einzigen Schreibzyklus (NVWR) in den nichtflüchtigen Speicherzellen (EE) der jeweiligen Speicherpunkte registrieren.

7. Vorrichtung nach Anspruch 6, wobei die Schreibverarbeitungsmittel (MTE) so ausgelegt sind, dass der Schreibzyklus (NVWR) unabhängig von der Größe der von den Protokollverarbeitungsmitteln (MTP) empfangenen Daten (DAT) eine konstante Dauer aufweist.

8. Vorrichtung nach einem der Ansprüche 6 oder 7, die weiter eine kapazitive Schaltung (CAP) umfasst, die so ausgelegt ist, dass sie beim Empfang und dem Speichern der Daten durch die Protokollverarbeitungsmittel (MTP) Energie (E_ANT) in ausreichender Menge speichert, um die Schreibverarbeitungsmittel (MTE) im Schreibzyklus (NVWR) autonom mit Energie zu versorgen, und um die Schreibverarbeitungsmittel (MTE) beim Registrieren zu versorgen (E_CAP).

9. Vorrichtung nach einem der Ansprüche 6 bis 8, wobei die Protokollverarbeitungsmittel (MTP) so ausgelegt sind, dass sie nur die empfangenen Daten (DAT) in den flüchtigen Speicherzellen (FF) der entsprechenden Speicherpunkte speichern, und der Speicher (MEM) so ausgelegt ist, dass er früher in den nichtflüchtigen Speicherzellen (EE) anderer Speicherpunkte registrierte Daten nicht erneut in die flüchtigen Speicherzellen (FF) der anderen Speicherpunkte lädt.

10. Vorrichtung nach einem der Ansprüche 6 bis 9, wobei die Schreibverarbeitungsmittel (MTE) so ausgelegt sind, dass sie im Schreibzyklus (NVWR) in allen Speicherpunkten (PTM) des Speichers Schreibimpulse erzeugen, wobei die Schreibimpulse geeignet sind, das automatisch von den jeweils in den flüchtigen Speicherzellen (FF) der jeweiligen Speicherpunkte gespeicherten Daten (DAT) bedingte Registrieren der Daten (DAT) in den nichtflüchtigen Speicherzellen (EE) zu bewirken.

## Claims

1. Method for writing data in a memory (MEM) of a contactless transponder (TRSP), the memory being a non-volatile static random-access memory including memory points (PTM) each comprising a volatile memory cell (FF) and a non-volatile memory cell (EE), the method comprising a protocol phase (PP) comprising a reception of data (DAT), and a storage of the data received (LTCH) in the volatile memory cells (FF) of the memory, and, at the end of the protocol phase (PP), a write phase (WP) comprising a single write cycle (NVWR) recording the data received and stored in the volatile memory cells (FF), in the non-volatile memory cells (EE) of the respective memory points.

2. Method according to claim 1, wherein said write cycle (NVWR) of the write phase (WP) has a constant duration (T2-T1), whatever the size of the data received during the protocol phase (PP).

3. Method according to one of claims 1 or 2, further comprising, during the protocol phase (PP), a storage of energy by a capacitive circuit (CAP) in sufficient quantity to supply the write phase (WP) with energy autonomously, and, during the write phase (WP), a supply of the memory (MEM) with the energy stored by the capacitive circuit (CAP).

4. Method according to one of the preceding claims, wherein only the data (DAT) received during the protocol phase (PP) are stored in the volatile memory cells (FF) of the corresponding memory points (PTM), and data previously stored in the non-volatile memory cells (EE) of other memory points are not reloaded in the volatile memory cells (FF) of said other memory points.

5. Method according to one of the preceding claims, wherein the single write cycle (NVWR) comprises a generation of writing stimuli in all the memory points (PTM) of the memory, the writing stimuli being adapted for causing the recording of said data in the non-volatile memory cells (EE) in a way that is automatically determined by the data respectively stored in the volatile memory cells (FF) of the respective memory points (PTM).

6. Contactless transponder device (TRSP) including a non-volatile static random access memory (MEM) including memory points (PTM) each comprising a volatile memory (FF) and a non-volatile memory cell (EE), protocol processing means (MTP) configured to receive data (DAT), and to store (LTCH) received data (DAT) in the volatile memory cells (FF) of the memory, along with write processing means (MTE) configured, at the end of the reception and storage of the data (DAT), to record, in a single write cycle (NVWR), the received data stored in the volatile memory cells (FF), in the non-volatile memory cells (EE) of the respective memory points.

7. Device according to claim 6, wherein the write processing means (MTE) are configured so that said write cycle (NVWR) has a constant duration, whatever the size of the data (DAT) received by the protocol processing means (MPT).

8. Device according to one of claims 6 or 7, further comprising a capacitive circuit (CAP) configured to store energy (E_ANT), during the reception and storage of the data by the protocol processing means (MTP), in sufficient quantity to supply energy autonomously to the write processing means (MTE) during said write cycle (NVWR), and to supply (E_CAP) the write processing means (MTE) during said recording.

9. Device according to one of claims 6 to 8, wherein the protocol processing means (MTP) are configured to store only the data received (DAT) in the volatile memory cells (FF) of the corresponding memory points, and the memory (MEM) is configured not to reload data previously recorded in the non-volatile memory cells (EE) of other memory points, in the volatile memory cells (FF) of said other memory points.

10. Device according to one of claims 6 to 9, wherein the write processing means (MTE) are configured, during said write cycle (NVWR), to generate writing stimuli in all the memory points (PTM) of the memory, the writing stimuli being adapted for causing the recording of said data (DAT) in the non-volatile memory cells (EE) in a way that is automatically determined by the data (DAT) respectively stored in the volatile memory cells (FF) of the respective memory points.
